**Europäisches Patentamt**

(19) **European Patent Office**

**Office européen des brevets**

(11) Veröffentlichungsnummer: **0 008 694**
**B1**

(12) **EUROPÄISCHE PATENTSCHRIFT**

(45) Veröffentlichungstag der Patentschrift:
**23.02.83**

(21) Anmeldenummer: **79102863.2**

(22) Anmeldetag: **08.08.79**

(51) Int. Cl.³: **H 05 K 13/02**, G 02 B 27/00

(54) Vorrichtung zum Bestücken von Leiterplatten und Verfahren zum Programmieren des Programmspeichers in der Vorrichtung.

(30) Priorität: **11.08.78 DE 2835341**

(43) Veröffentlichungstag der Anmeldung:
**19.03.80 Patentblatt 80/6**

(45) Bekanntmachung des Hinweises auf die Patenterteilung:
**23.02.83 Patentblatt 83/8**

(84) Benannte Vertragsstaaten:
**AT BE CH DE FR GB IT NL SE**

(56) Entgegenhaltungen:
**DD-A-122 459**
**DE-A-2 131 662**
**DE-A-2 547 750**

(73) Patentinhaber: **Lemmer, Alfred, Machtlfingerstrasse 24, D-8000 München 70 (DE)**

(72) Erfinder: **Lemmer, Alfred, Machtlfingerstrasse 24, D-8000 München 70 (DE)**

(74) Vertreter: **Schmidt-Evers, Jürgen, Patentanwälte Dipl.-Ing.H.Mitscherlich Dipl.-Ing.K.Gunschmann Dr.rer.nat.W.Körber Dipl.-Ing.J.Schmidt-Evers, Steinsdorfstrasse 10 D-8000 München 22 (DE)**

ACTORUM AG

Vorrichtung zum Bestücken von Leiterplatten und Verfahren zum Programmieren des Programmspeichers in der Vorrichtung.

Die Erfindung betrifft eine Vorrichtung zum Bestücken von Leiterplatten, mit einer Beleuchtungsoptik zum Beleuchten mindestens eines zu bestückenden Loches, die über der zu bestückenden Leiterplatte bewegbar angeordnet ist.

Eine derartige Vorrichtung ist bekannt (US-Zeitschrift "American machinist" Bd. 112, Nr. 11 vom 20.5.1968, S. 125 bis 127).

Die bekannte Vorrichtung weist ein Montagepult auf, auf dem die Leiterplatte angeordnet ist. An dem Montagepult sitzt die die Leiterplatte bestückende Person. Oberhalb des Kopfes dieser Person ist ein Projektor angeordnet. Der Projektor enthält eine Maske mit Löchern oder Schlitzen, die in 45°-Schritten gedreht werden kann. Ausserdem kann die Position des Projektors selbst durch Schwenken verändert werden, um die Lichtsymbole auf ausgewählte Teile der Leiterplatte richten zu können.

Die Steuerung der Schwenkposition des Projektors sowie der Drehposition der Maske im Projektor erfolgt mittels eines das Steuerprogramm aufweisenden Lochbandes.

Wird bei dem bekannten System der Lichtstrahl durch entsprechende Schwenkung des Projektors in einen äusseren Bereich der Leiterplatte gelenkt, so fällt er schräg auf die Leiterplatte, d. h. er bildet mit der Leiterplatte einen spitzen Winkel. Dadurch besteht die Gefahr, dass bereits auf der Leiterplatte befindliche grössere Bauelemente daneben liegende Löcher abschatten können, was sich insbesondere hinsichtlich der Tendenz zur Verkleinerung der Leiterplatten, d. h. zur Verengung des Lochrasters äusserst störend bemerkbar macht.

Bekannt ist ferner eine Vorrichtung zum Bestücken von Leiterplatten (DE-AS 11 32 610) bei der auf einer Unterlage neben der zu bestückenden Leiterplatte eine Modellplatte angeordnet werden muss. Die Modellplatte ist mit Bohrungen versehen, die den zu bestückenden Löchern auf der Leiterplatte entsprechen. Über der Leiterplatte und der Modellplatte befindet sich ein Schlitten, der wiederum gleitend auf einem festen Gestell angeordnet ist. Der Schlitten enthält einen längsverschieblichen Abtastarm, an dessen einem Ende sich ein Taststift und an dessen anderem Ende sich eine Beleuchtungsoptik befindet. Mit dem Taststift werden die Bohrungen in der Modellplatte nacheinander abgetastet. Die Beleuchtungsoptik ist mit einer Maske versehen, mittels welcher Bestückungssymbole auf die zu bestückende Leiterplatte gerichtet werden können. Das Verschieben des Schlittens und des Abtastarmes erfolgt von Hand. Ferner muss jedesmal dann, wenn der Abtaststift in eine Bohrung der Modellplatte eintaucht, von Hand ein Schalter betätigt werden, der an der Beleuchtungsoptik ein bestimmtes Bestückungssymbol einschaltet. Die Bohrungen der Modellplatte müssen in einer bestimmten Reihenfolge nacheinander abgetastet werden, da die Folge der an der Beleuchtungsoptik eingeschalteten Bestückungssymbole für die einzelnen Bauelemente entsprechend dieser Reihenfolge festliegt.

Bei der zuletzt beschriebenen bekannten Vorrichtung kann die Beleuchtungsoptik zwar parallel zu der bestückenden Leiterplatte verfahren und damit ein weitgehend senkrechter Lichteinfall gewährleistet werden, wodurch das zuvor beschriebene Abschatten nicht auftritt; die Vorrichtung ist jedoch wegen der Notwendigkeit den Schlitten und den Abtastarm von Hand verstellen zu müssen, für einen modernen Bestückungsbetrieb zu langsam und daher ungeeignet. Hinzu kommt, dass die die Bestückung vornehmende Person ihre Aufmerksamkeit nicht nur auf die zu bestückende Leiterplatte, sondern ausserdem auf die Modellplatte richten muss, wobei bei deren Abtastung zusätzlich noch eine bestimmte Reihenfolge der Bohrungen einzuhalten und bei jeder Bohrung ein Tastschalter zu betätigen ist.

Der Erfindung liegt die Aufgabe zugrunde, bei einer Bestückungsvorrichtung, die die zu bestückenden Löcher in der Leiterplatte möglichst schnell und automatisch nacheinander anfahren kann, zu gewährleisten, dass die zur Lochbeleuchtung dienenden Lichtstrahlen senkrecht oder nahezu senkrecht auf die Leiterplatte fallen.

Ausgehend von der eingangs beschriebenen Vorrichtung besteht die Lösung der Erfindung darin, dass die Beleuchtungsoptik von einem pantographischen Hebelgestränge getragen und in einer Ebene parallel zur Leiterplatte verfahrbar ist.

Eine zweckmässige Ausgestaltung der Erfindung kann darin bestehen, dass das pantographische Hebelgestänge mit einem Koordinatenschlitten verbunden ist.

Die Beleuchtungsoptik kann aus einer parallel zur Leiterplatte projizierenden Projektionseinrichtung und einem am Ende des die Beleuchtungsoptik tragenden Armes des pantographischen Hebelgestänges angeordneten Spiegel bestehen, der die Projektionsstrahlen senkrecht auf die Leiterplatte umlenkt. Da der Arm mit dem Spiegel die Sicht kaum behindert, kann er in relativ geringer Höhe über der Leiterplatte angeordnet werden. Dies bringt den Vorteil mit sich, dass die Lichtstärke der Optik relativ gering sein kann. Ein weiterer Vorteil ist, dass die Lage des Spiegels über der Leiterplatte der Person, die die Bestückung vornimmt, bereits eine Grobinformation gibt, an welcher Stelle der Leiterplatte die beleuchteten Löcher zu finden sind.

Die weiteren in den Unteransprüchen angegebene Ausbildung der Erfindung, in Form der Verwendung eines Schiebers mit Löchern und einem Schlitz, sowie einer im Schlitzbereich angeordneten verschiebbaren Blende bringt den Vorteil mit sich, dass die Länge eines durch den Schlitz erzeugten Lichtbalkens stets so gewählt werden kann, dass er sich genau zwischen zwei zu bestückenden Löchern erstreckt, d. h. nicht kürzer und nicht länger ist. Dies erleichtert das Bestücken erheblich.

Ferner kann durch die Verwendung des zweiten Loches in dem Schieber, welches in einem lichtdurchlässigen farbigen Material gefüllt oder abgedeckt ist, die Polarität für die Bauelemente angezeigt werden, die in die betreffenden Löcher eingesetzt werden sollen, zwischen denen sich der Lichtbalken erstreckt. Die Form der beiden Löcher in dem Schieber kann beliebig gewählt werden. Es können hierfür besondere geometrische Formen gewählt werden, die Bestückungssymbole repräsentieren.

Die Steuerung der erfindungsgemässen Vorrichtung erfolgt durch eine Steuerungselektronik, die programmiert werden kann.

Ein Ausführungsbeispiel der Erfindung wird nachfolgend anhand der Zeichnung beschrieben.

Es zeigen:

Fig. 1 eine Prinzipdarstellung der erfindungsgemässen Vorrichtung;

Fig. 2a–e verschiedene Lichtsymbole, welche mit der Vorrichtung auf die zu bestückende Leiterplatte projeziert werden können;

Fig. 3a–f die verschiedenen Stadien beim Programmieren und beim Bestücken mit der Vorrichtung;

Fig. 4 einen Schnitt durch die Beleuchtungsoptik;

Fig. 5 eine Ansicht V auf die Beleuchtungsoptik in Fig. 4;

Fig. 6 eine Ansicht von oben auf die Vorrichtung;

Fig. 7 eine Ansicht VII-VII auf einen Teil von Fig. 6;

Fig. 8 ein Blockschaltbild des Elektronikteiles der Vorrichtung.

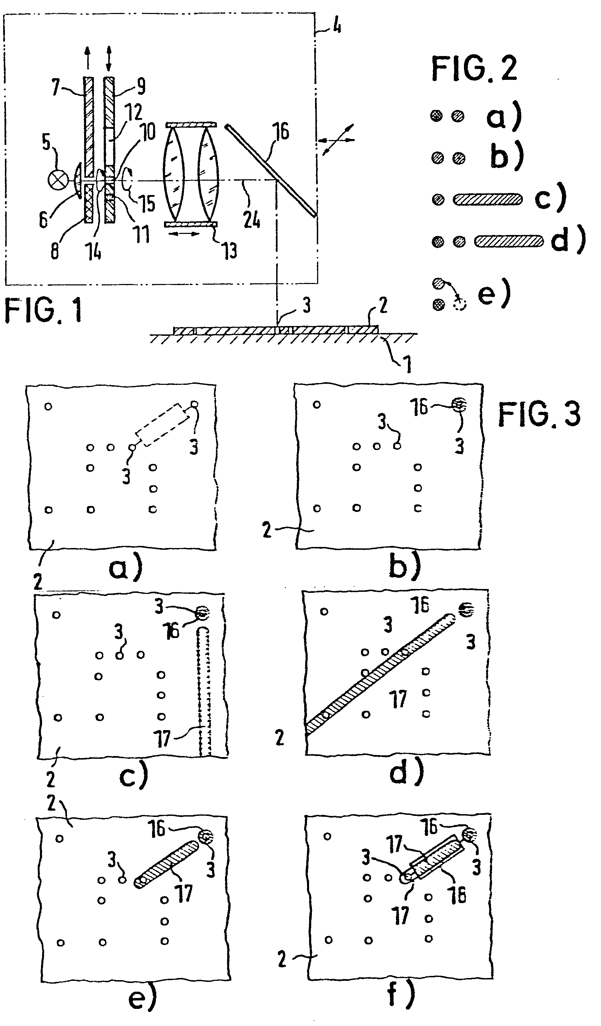

Fig. 1 zeigt eine Unterlage 1, beispielsweise in Form eines Bestückungstisches, auf dem eine zu bestückende Leiterplatte 2 liegt, in der Löcher 3 vorgesehen sind. In die Löcher 3 sollen die Anschlussdrähte von Bauelementen gesteckt werden.

Über der Leiterplatte 2 ist eine Vorrichtung 4 in zwei Koordinatenrichtungen verfahrbar angeordnet. Die Vorrichtung 4 enthält eine Projektorlampe 5, in deren Lichtweg eine Linse 6 angeordnet ist. Hinter der Linse 6 befindet sich ein Schieber 9, der senkrecht zur optischen Achse 24 der Linse verschiebbar ist. Der Schieber 9 enthält ein erstes Loch 10, ein zweites Loch 11 und einen in Verschieberichtung verlaufenden Schlitz 12. Die beiden Löcher 10, 11 und der Schlitz 12 sind auf einer Linie in Verschieberichtung angeordnet.

Das Loch 11 ist mit einem farbigen lichtdurchlässigen Material gefüllt. Das Loch 11 befindet sich in Bezug auf den Schlitz 12 jenseits des Loches 10. Zwischen dem Schieber 9 und der Linse 6 ist eine Blende 7 angeordnet. Die Blende 7 kann parallel zu dem Schieber 9, d.h. also senkrecht zur optischen Achse 24 verschoben werden. Fig. 1 ist die Blende 7 in unterer Endstellung gezeigt. Fluchtend mit der verschiebbaren Blende 7 ist eine feststehende Blende 8 angeordnet. Die feststehende Blende 8 und die verschiebbare Blende 7 lassen, wenn sich die Blende 7 in ihrer unteren Endstellung befindet, gerade einen Bereich frei, der dem Durchmesser des Loches 10 entspricht.

Hinter dem Schieber 9 ist ein Objektiv 13 angeordnet, das in Richtung der optischen Achse 24 verschiebbar angeordnet ist, um den Lichtpunkt scharfstellen zu können. Auf das Objektiv 13 folgt in Strahlrichtung ein Spiegel 16, der unter einem Winkel von 45° zur optischen Achse angeordnet ist und den Lichtstrahl senkrecht auf die zu bestückende Leiterplatte 2 umlenkt.

Der Schieber 9 ist, wie durch den Pfeil 15 angedeutet, um die optische Achse 24 drehbar. Mit dem Schieber 9 drehbar sind ebenfalls die verschiebbare Blende 7 und die feststehende Blende 8, wie dies durch den Pfeil 14 angedeutet ist.

Wenn die Blende 7 von der optischen Achse 24 weggeschoben wird, so gibt sie den Schlitz 12 in dem Schieber 9 frei. Dadurch erscheint auf der zu bedruckenden Leiterplatte 2 ein etwa kreisförmiger Lichtfleck sowie ein Lichtbalken. Der kreisförmige Lichtfleck wird von dem Loch 10 hervorgerufen. Der Lichtbalken entsteht durch den Schlitz 12. Die Länge des Lichtbalkens hängt davon ab, wieweit die Blende 7 von der optischen Achse 24 zurückgezogen worden ist.

Der Schieber 9 kann zwischen zwei Stellungen verschoben werden. In der in Fig. 1 gezeigten Stellung fluchtet das Loch 10 mit der optischen Achse 24. Das Loch 10 erzeugt einen weiten Lichtfleck. In der anderen Verschiebestellung fluchtet das mit lichtdurchlässigem farbigem Material gefüllte Loch 11 mit der optischen Achse 24. Dadurch erscheint ein farbiger Lichtfleck auf der zu bestückenden Leiterplatte 2. Mit dem farbigen Lichtfleck kann die Polarität eines Bauelementes angezeigt werden. Beispielsweise kann bei einer Diode angezeigt werden, in welches von zwei Löchern der Anschlussdraht für die Anode bzw. Kathode einzuführen ist.

In Fig. 2 sind die einzelnen Lichtmuster dargestellt, die mit der Vorrichtung erzeugt werden können. Figur 2a zeigt zwei Lichtpunkte, von denen der linke (doppeltschraffiert) beispielsweise ein roter Lichtpunkt ist, während der rechte ein weisser Lichtpunkt ist. Der Abstand der beiden Lichtpunkte entspricht dem Rastermass der zu bestückenden Leiterplatte. Um dieses Lichtmuster zu erzeugen, muss der Schieber 9 so verschoben werden, dass das Loch 11 mit der optischen Achse 24 fluchtet. Ferner muss die Blende 7 soweit zurückgeschoben sein, dass sie das Loch 10 noch freigibt, aber den Schlitz 12 verdeckt.

Fig. 2b zeigt ein Lichtmuster mit zwei weissen Lichtpunkten. Um dieses Lichtmuster zu erzeugen, muss der Schieber 9 in der in Fig. 1 gezeigten Stellung sein. Das bedeutet, dass das Loch 10 mit der optischen Achse 24 fluchtet. Die Blende 7 muss soweit zurückgezogen sein, dass sie einen kurzen Abschnitt des Schlitzes 12 freigibt.

Das Lichtmuster in Fig. 2c zeigt einen weissen Lichtfleck und einen Lichtbalken. Um dieses Lichtmuster zu erzeugen, muss das Loch 10 in dem Schieber 9 mit der optischen Achse 24 fluchten und die Blende 7 soweit zurückgezogen sein, dass sie einen Teil des Schlitzes 12 freigibt.

Zur Erzeugung des Lichtmusters gemäss Fig. 2d muss das Loch 11 in dem Schieber 9 mit der optischen Achse 24 fluchten und die Blende 7 soweit zurückgezogen sein, dass sie sowohl das Loch 10 als auch einen Teil des Schlitzes 12 freigibt. In diesem Fall erscheinen ein roter Lichtfleck, ein weisser Lichtfleck und ein weisser Lichtbalken.

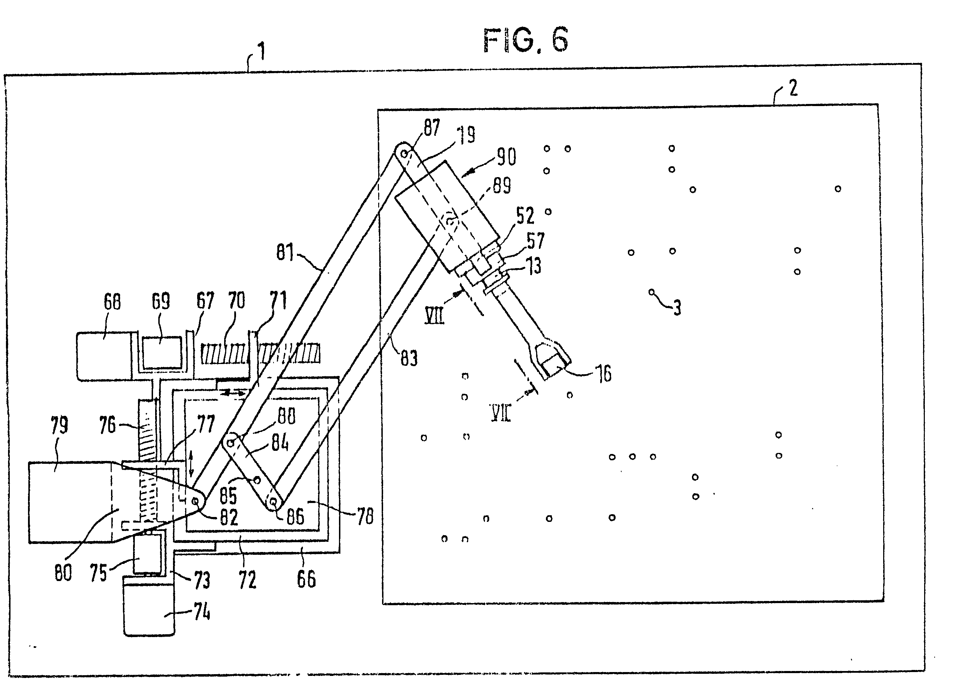

Das Lichtmuster gemäss Fig. 2e dient beispielsweise zur Anzeige von drei Löchern, in die beispielsweise die Anschlussdrähte eines Transistors gesteckt werden sollen. Dabei erscheint ein roter Lichtfleck, sowie ein weisser Lichtfleck wobei der weisse Lichtfleck um den roten Lichtfleck oszillierend dreht. Um dieses Lichtmuster zu erreichen, muss der Schieber 9 so eingestellt sein, dass das Loch 11 mit der optischen Achse 24 fluchtet. Gleichzeitig muss die Blende 7 soweit zurückgezogen sein, dass sie das Loch 10 freigibt, jedoch den Schlitz 12 verdeckt. Ferner müssen der Schieber 9, die Blende 7 und die Blende 8 um die optische Achse oszillierend gedreht werden. Eine praktische Ausführungsform des in Fig. 1 schematisch dargestellten Vorrichtungsteiles 4 zeigt die Fig. 6. Auf einem Bestückungstisch 1 befindet sich eine zu bestückende Leiterplatte 2 mit Löchern 3. Neben der Leiterplatte 2 ist ein Koordinatentisch angeordnet. Dieser besteht aus einer auf dem Bestückungstisch 1 befestigten Grundplatte 66, an der mit einem Winkel 67 ein Schrittmotor 68 befestigt ist. Der Schrittmotor treibt über eine Kupplung 69 eine Gewindespindel 70 an. Die Gewindespindel 70 durchgreift ein Winkelstück 71 mit Innengewinde. Das Winkelstück 71 ist in einem ersten Schlitten 72 befestigt, der in Richtung des Doppelpfeiles auf der Grundplatte 66 verschiebbar angeordnet ist. Mittels eines Winkels 73 ist an dem ersten Schlitten 72 ein weiterer Schrittmotor 74 befestigt. Dieser treibt über eine Kupplung 75 eine Gewindespindel 76 an. Die Gewindespindel 76 durchgreift ein Winkelstück 77 mit Innengewinde. Das Winkelstück 77 ist an einem zweiten Schlitten 78 befestigt, der senkrecht zur Verschieberichtung des ersten Schlittens 72 in Richtung des Doppelpfeiles verschiebbar ist.

Neben dem Koordinatentisch befindet sich ein Ständer 79 mit einem aufkragenden Trägerelement 80, das den Koordinatentisch teilweise übergreift. An dem Trägerelement ist ein Hebelgestänge befestigt, das nach Art eines Pantographen ausgebildet ist. Dieses Trägergestänge besteht aus zwei langen Armen 81, 83 und zwei kurzen Armen 19, 84. Der lange Arm 81 ist mittels eines Gelenkes 82 an dem Trägerelement 80 befestigt. Der kurze Arm 84 ist mit dem langen Arm 81 durch ein Gelenk 88 miteinander verbunden. Das Gelenk 88 liegt wesentlich näher an dem Gelenk 82 als an dem Gelenk 87. Ferner ist der kurze Arm 84 mit dem langen Arm 83 durch ein Gelenk 86 miteinander verbunden. Der kurze Arm 19 ist mit dem langen Arm 83 durch ein Gelenk 89 miteinander verbunden. Die langen Arme 83, 81 und die kurzen Arme 84, 19 bilden miteinander ein Gelenkviereck oder Parallelogramm. Der lange Arm 81 ist praktisch über den Gelenkpunkt 88 mit dem kurzen Arm 84 hinaus verlängert, um an dem Trägerelement befestigt zu werden. Der kurze Arm 19 ist über den Gelenkpunkt 89 hinaus verlängert. Der kurze Arm 84 ist mit einem Gelenkpunkt 85 an dem zweiten Koordinatenschlitten 78 befestigt und macht dessen Bewegung mit.

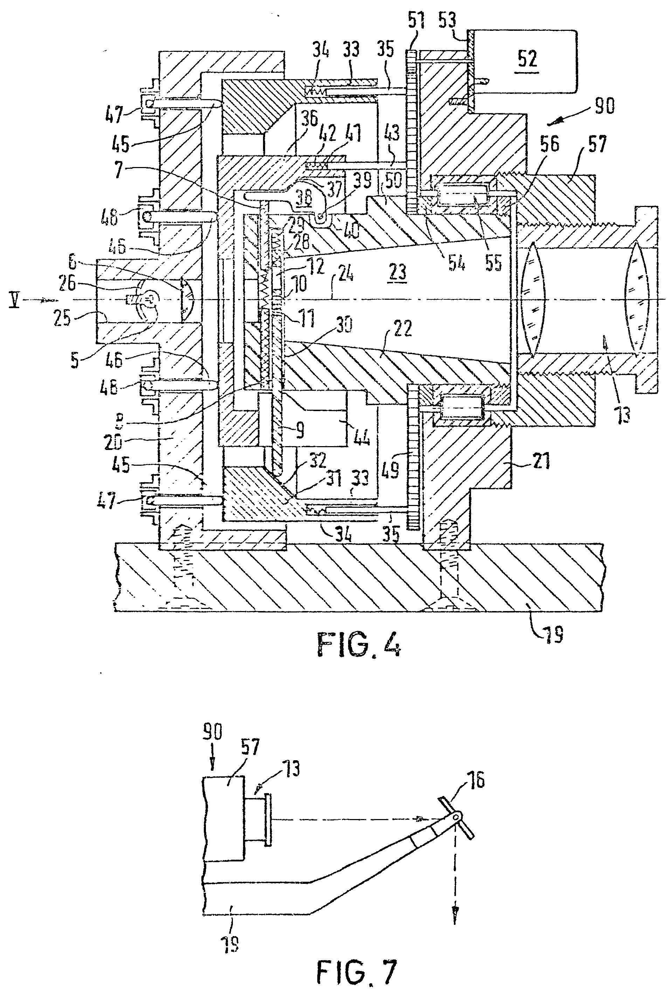

Auf dem Arm 19 sitzt der optische Vorrichtungsteil 90, der genauer in Fig. 4 dargestellt ist. Am verlängerten und gabelförmig ausgebildeten Ende des kurzen Armes 19 ist der Spiegel 16 angeordnet. Die entsprechende Ansicht des Endbereiches des Armes 19 und des vorderen Bereiches des optischen Vorrichtungsteiles 90 ist in Fig. 7 in Seitenansicht gezeigt.

Gemäss Fig. 4 besteht der optische Vorrichtungsteil aus zwei Gehäuseabschnitten 20, 21, die auf dem Arm 19 befestigt sind. In dem Gehäuseteil 21 ist ein zylindrisches Drehteil 22 drehbar gelagert. Das Drehteil 22 ist mit einem Vorsprung 50 versehen, gegen den sich ein Zahnrad 49 abstützt. An dem Zahnrad liegt ein Distanzring 54 an, gegen welchen sich der Innenkäfig eines Rollenlagers 55 abstützt. Der Innenkäfig wird mittels einer Ringmutter 56 gegen den Distanzring 54 gedrückt. Der Aussenkäfig des Rollenlagers 55 stützt sich an einem Vorsprung des Gehäuseteiles 21 ab, gegen den es durch eine Ringmutter 57 gedrückt wird, die innen in den Gehäuseteil 21 eingeschraubt ist. Die Ringmutter 57 weist ferner ein Innengewinde auf, in das das Objektiv 13 eingeschraubt ist.

Das Drehteil 20 ist mit einer Schlitzführung 30 für den Schieber 9, die verschiebbare Blende 7 und die fest Blende 8 versehen. Die feste Blende 8 ist mit dem Drehteil 22 fest verbunden. Die verschiebbare Blende 7 stützt sich an der festen Blende 8 mittels Federn 28 ab, die strichpunktiert angedeutet sind. Die Federn 28 liegen zu beiden Seiten der optischen Achse 24.

Das Drehteil 22 ist von einem Konusring 31 umgeben, der einen Innenkonus 32 aufweist, an dem das aus dem Drehteil 22 herausschauende Ende des Schiebers 9 gleitend gelagert ist. Das in dem Drehteil 22 befindliche Ende des Schiebers 9 stützt sich über eine Feder 29 an dem Drehteil 22 ab und drückt dieses gegen den Innenkonus 32. Der Konusring 31 weist mehrere parallel zur optischen Achse 24 verlaufende Sacklochbohrungen 33 auf, in die Stifte 35 ragen, welche sich über Federn 34 an dem Grund der Sacklochbohrungen abstützen. Die Stifte sind an dem Zahnrad 49 befestigt. Wenn der Konusring 31 parallel zur optischen Achse 24 verschoben wird, so gleitet der Schieber 9 mit seinem freien Ende an dem Innenkonus 32 und verschiebt sich senkrecht zur optischen Achse.

In dem Konusring 31 ist ein Verstellring 36 konzentrisch zur optischen Achse 24 und zum Konusring 31 angeordnet. Der Verstellring 36 weist ebenfalls einen Innenkonus 37 auf. An diesem liegt ein Nockenvorsprung eines Übersetzungshebels 38 an, der in einer Ausnehmung 40 des Drehteiles 22 gelagert ist. Der Übersetzungshebel ist mit einem Hebelfortsatz versehen, der in Kontakt mit dem aus dem Drehteil 22 herausschauenden Ende verschiebbaren Blende 7 in Kontakt steht. Der Kontaktpunkt zwischen dem Übersetzungshebel 38 und der verschiebbaren Blende 7 weiter von dem Drehpunkt 39 entfernt als der Nockenvorsprung, mit dem der Übersetzungshebel 38 an dem Innenkonus 37 anliegt. Der Verstellring 36 weist mehrere über den Umfang verteilte Sacklochbohrungen 41 auf, in die je ein Stift 43 hineinragt, der an dem Zahnrad 49 befestigt ist. Jeder Stift 43 stützt sich über eine Feder 42 auf dem Grund der Sacklochbohrung ab. Dadurch kann der Verstellring 36 parallel zur optischen Achse 24 verschoben werden, wobei die Federn 42 versuchen, den Verstellring 36 nach links zu drücken. Durch eine Verschiebung des Verstellringes 36 parallel zur optischen Achse 24 wird der Übersetzungshebel 38 geschwenkt, wobei eine geringe Verschiebung zu einem relativ grossen Schwenkweg, d. h. zu einer relativ grossen Verschiebung der verschiebbaren Blende 7 führt.

In dem Gehäuseteil 20 befindet sich eine zentrale Bohrung 25, in der sich die Projektorbirne 5 mit Reflektionsspiegel 26 und die Linse 6 befinden.

Das Gehäuseteil 21 ist mit einer angeschraubten Platte 53 versehen, an der ein Schrittmotor 52 befestigt ist. Die Achse des Schrittmotors 52 durchgreift das Gehäuseteil 21 und trägt an ihrem Ende ein Ritzel 51, das mit dem Zahnrad 49 kämmt. Durch Betätigung des Schrittmotors 52 kann also das Drehteil 22 gedreht werden.

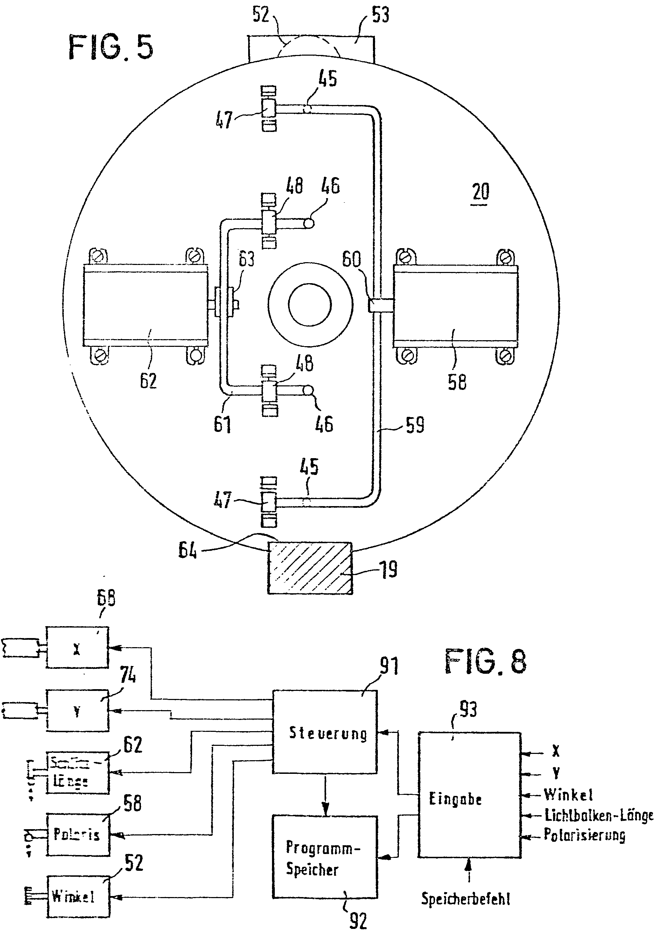

Das Gehäuseteil 20 ist mit vier Löchern versehen, die von Gleitelementen 45, 46 durchgriffen werden. Wie man der Fig. 5 entnehmen kann, sind die Gleitelemente 45 durch einen Gelenkbügel 59 miteinander verbunden, der an seinen beiden Enden mit Lagern 47 an dem Gehäuseteil 20 befestigt ist. Auf die Gleitelemente 45 wirkt der Druck der Federn 34. Der Gelenkbügel 59 hat daher eine von dem Gehäuseteil 20 weggerichtete Spannung. Er wird von der schrägen Ebene am Ende des Ankers 60 eines Elektromagneten 58 übergriffen, der zwischen zwei Stellungen umschaltbar ist. In der einen Stellung wird der Konusring 31 so angeordnet, dass er den Schieber 9 in eine Stellung drückt, in der wie in Fig. 4 gezeigt, das Loch 10 mit der optischen Achse 24 fluchtet. In der anderen Stellung nimmt der Konusring eine Position ein, in der der Schieber 9 so ausgerichtet ist, dass das Loch 11 mit der optischen Achse 24 fluchtet.

Die Gleitelemente 46 sind ebenfalls miteinander verbunden und zwar durch einen Gelenkbügel 61, der durch zwei Lager 48 schwenkbar an der Stirnseite des Gehäuseteiles 20 angelenkt ist. Auf die Gleitelemente 46 wirkt der Druck der Federn 42. Der Gelenkbügel 61 hat daher die Tendenz, sich an die Stirnseite des Gehäuseteiles 20 anzulegen. Er wird jedoch von einer auf der Achse eines Schrittmotors 62 angeordneten Nokke 63 untergriffen. Beim Drehen der Nocke 63 stossen die Gleitelemente 46 den Verstellring entgegen der Wirkung der Federn 42 mehr oder weniger weit von dem Gehäuseteil 20 weg. Dadurch wird, wie erläutert, die verschiebbare Blende 7 mehr oder weniger weit von der optischen Achse 24 entfernt.

In Fig. 8 ist der elektronische Schaltungsteil für die Vorrichtung als Blockschaltbild dargestellt. In einen Eingabeteil 93 werden zunächst die Befehle für die X-Bewegung und die Y-Bewegung der beiden Schrittmotoren 68, 74 des Koordinatentisches eingegeben. Die eingegebenen X- und Y-Steuerbefehle werden von einem Steuerteil 91 in elektrische Signale umgewandelt. Durch das Verschieben des Koordinatentisches wird in Fig. 6 der Spiegel 16 entsprechend parallel über der zu bestückenden Leiterplatte 2 verschoben. Dabei ist zunächst die verschiebbare Blende 7 geschlossen, so dass nur ein einziger Lichtpunkt erscheint.

Wenn beispielsweise gemäss Fig. 3 zwei Löcher 3, zwischen denen sich ein elektrisches Bauelement erstrecken soll, für ein wiederholtes Beleuchten einprogrammiert werden sollen, so wird der Lichtpunkt 16 gemäss Fig. 2b zunächst auf das eine Loch 3 gefahren. Dann wird dem Eingabeteil 93 ein Speicherbefehl eingegeben, wodurch die X- und Y-Koordinaten bzw. die ihnen entsprechenden elektrischen Signale des Steuerteiles 91 in einem Programmspeicher 92 abgespeichert werden.

Dann wird die Blende 7 in ihrer äusserste Endstellung zurückgefahren, so dass der Schlitz 12 in dem Schieber 9 vollständig freigegeben wird. Es erscheint dann auf der zu bestückenden Leiterplatte gemäss Fig. 3c neben dem Lichtpunkt 16 ein Lichtbalken 17, der zunächst noch ungerichtet ist. Durch Betätigung eines Knopfes am Eingabeteil 93 zur Winkelverstellung wird nunmehr der Schrittmotor 52 in Betrieb gesetzt. Dadurch bewegt sich der Lichtbalken 17 kontinuierlich radial um den Lichtpunkt 16 herum. Wenn der Lichtbalken 17 gemäss Fig. 3d über das andere Loch 3 hinwegstreicht, wird die Winkelbewegung abgestoppt und der Winkel durch einen entsprechenden Speicherbefehl im Programmspeicher 92 abgespeichert.

Danach wird durch Drücken eines Knopfes die Lichtbalken-Länge der Schrittmotoren 62 in Betrieb gesetzt. Dieser bewirkt, dass die Blende 7 fortschreitend gegen die optische Achse 24 gefahren wird. Wenn das Ende des Lichtbalkens 17 über dem anderen zu bestückenden Loch 3 steht, wie dies in Fig. 3e angedeutet ist, so wird die Lichtbalken-Verkürzung abgestoppt und die Lichtbalken-Länge durch Speicherbefehl in den Programmspeicher 92 abgespeichert.

Damit sind nunmehr gemäss Fig. 3f die Position des Lichtpunktes 16 sowie die Position, die Länge und der Winkel des Lichtbalkens 17 als Festwerte gespeichert und können neben anderen gleichartigen Werten wiederholt für dieses Bestückungsbild abgerufen werden. Entsprechend diesem Bestückungsbild kann dann das Bauelement 18 mit seinen Anschlüssen in die Löcher 3 eingesetzt werden.

Wenn das Bauelement 18 in einer bestimmten Weise in die Löcher 3 eingesetzt werden muss, weil beispielsweise eine Polarisierung beachtet werden muss, so ist die Version 2d zu wählen.

**Ansprüche:**

1. Vorrichtung zum Bestücken von Leiterplatten, mit einer Beleuchtungsoptik zum Beleuchten mindestens eines zu bestückenden Loches, die über der zu bestückenden Leiterplatte bewegbar angeordnet ist, dadurch gekennzeichnet, dass die Beleuchtungsoptik (90, 16) von einem pantographischen Hebelgestänge (19, 81, 83, 84) getragen und in einer Ebene parallel zur Leiterplatte (2) verfahrbar ist.

2. Vorrichtung nach Anspruch 1, dadurch gekennzeichnet, dass das pantographische Hebelgestänge (19, 81, 83, 84) mit einem Koordinatentisch (66, 72, 78) verbunden ist.

3. Vorrichtung nach Anspruch 1 oder 2, dadurch gekennzeichnet, dass die Beleuchtungsoptik aus einer parallel zur Leiterplatte (2) projizierenden Projektionseinrichtung (90) und einem am Ende des die Beleuchtungseinrichtung tragenden Armes (19) des pantographischen Hebelgestänges (19, 81, 83, 84) angeordneten Spiegel (16) besteht, der die Projektionsstrahlen senkrecht auf die Leiterplatte (2) umlenkt.

4. Vorrichtung nach einem der Ansprüche 1 bis 3, dadurch gekennzeichnet, dass die Beleuchtungsoptik einen in den Lichtweg einschiebbaren Schieber (9) enthält, der mindestens ein Loch (10) und einen Schlitz (12) aufweist, und dass der Schieber um 360° um die optische Achse (24) drehbar ist.

5. Vorrichtung nach Anspruch 4, dadurch gekennzeichnet, dass der Schieber (9) ein weiteres Loch (11) enthält, welches mit einem lichtdurchlässigen farbigen Material gefüllt ist, und dass dieses weitere Loch mit dem Schlitz und dem erstgenannten Loch in einer geraden Linie angeordnet ist.

6. Vorrichtung nach Anspruch 4 oder 5, dadurch gekennzeichnet, dass vor oder hinter dem Schieber (9) eine verschiebbare Blende (7) angeordnet ist, mittels welcher der Schlitz vollständig abdeckbar ist, und dass die Blende mit dem Schieber um 360° um die optische Achse drehbar ist.

7. Vorrichtung nach Anspruch 6, dadurch gekennzeichnet, dass der Schieber (9) und die Blende (7) in einem Drehteil (22) verschiebbar angeordnet sind, und dass das Drehteil (22) in einem Gehäuseteil (21) um die optische Achse drehbar angeordnet ist.

8. Vorrichtung nach Anspruch 7, dadurch gekennzeichnet, dass das Drehteil gegenüber dem Gehäuseteil mittels eines Schrittmotors (52) drehbar ist.

9. Vorrichtung nach Anspruch 8, dadurch gekennzeichnet, dass der Schrittmotor an dem Gehäuseteil (21) befestigt ist, dass mit der Drehachse des Schrittmotors (52) ein Ritzel (51) verbunden ist, und dass das Ritzel mit einem an dem Drehteil (22) befestigten Zahnrad (49) kämmt.

10. Vorrichtung nach Anspruch 8, dadurch gekennzeichnet, dass an dem Drehteil (22) ein das Drehteil umgreifender und gegenüber diesem in Richtung der optischen Achse verschiebbarer Konusring (31) vorgesehen ist, der eine zur optischen Achse schräg verlaufende Konusfläche aufweist, and der der Schieber (9) gleitend anliegt.

11. Vorrichtung nach Anspruch 8 bis 10, dadurch gekennzeichnet, dass an dem Drehteil (22) ein Verstellring (36) vorgesehen ist, der mit dem Drehteil drehbar aber gegenüber diesem in Richtung der optischen Achse verschiebbar ist, dass der Verstellring (36) einen Innenkonus (37) aufweist und dass die Blende ggf. unter Zwischenschaltung eines Übersetzungshebels durch Gleitkontakt mit dem Innenkonus verschiebbar ist.

12. Vorrichtung nach Anspruch 10, dadurch gekennzeichnet, dass der Konusring (31) durch stirnseitig anliegende Gleitelemente (45, 46) in Richtung der optischen Achse verstellbar ist, und dass die Gleitelemente über einen Gelenkbügel (59) zwischen zwei Stellungen durch einen Elektromagneten (58) in Richtung der optischen Achse verstellbar sind.

13. Vorrichtung nach Anspruch 12, dadurch gekennzeichnet, dass der Elektromagnet (58) auf den Gelenkbügel (59) mittels einer schrägen Ebene am Anker (60) des Elektromagneten einwirkt.

14. Vorrichtung nach Anspruch 13, dadurch gekennzeichnet, dass der Verstellring (36) mittels stirnseitig an ihm anliegender Gleitelemente (46) in Richtung der optischen Achse verstellbar ist, und dass die Gleitelemente (66) über einen Gelenkbügel (61) von einem Schrittmotor (62) mittels einer Nocke (63) in Richtung der optischen Achse verschiebbar sind.

15. Vorrichtung nach den Ansprüchen 11 u. 12, dadurch gekennzeichnet, dass eine elektronische Schaltung vorgesehen ist, welche eine Steuerung für den Schrittmotor (52) zum Drehen des Drehteils (22), den Elektromagneten (58) zum Verschieben des Schiebers (9), den Schrittmotor (62) zum Verschieben des Verstellrings (36), einen weiteren Schrittmotor (74) für den einen Koordinatenschlitten (78) des Koordinatentisches und noch einen weiteren Schrittmotor (68) für den anderen Koordinatenschlitten (72) aufweist, dass die Steuerung mit einem Eingabeteil (93) verbunden ist, in das Informationen für die beiden Koordinatenschlitten (72, 78), den Winkel und die Länge des Schlitzes sowie die Stellung des Schiebers (9) eingegeben werden, und dass ein Programmspeicher (92) vorgesehen ist, in welchem die in den Eingabeteil eingegebenen Informationen bzw. die entsprechenden Steuerungssignale der Steuerung abspeicherbar sind.

16. Verfahren zum Programmieren des Programmspeichers der Vorrichtung nach Anspruch 15, dadurch gekennzeichnet, dass zunächst die Blende so verschoben wird, dass sie den Schlitz in dem Schieber vollständig abdeckt, dass dann der durch das betreffende Loch in dem Schieber erzeugte Lichtpunkt durch Verfahren des Koordinatenschlittens in den beiden Koordinatenrichtungen auf ein zu bestückendes Loch der Leiterplatte gesetzt wird, dass dann die Koordinateninformationen des Koordinatenschlittens abgespeichert werden, dass dann die Blende vollständig zurückgefahren wird, so dass der Schlitz neben dem Lichtpunkt in voller Länge auf der Leiterplatte erscheint, dass dann die Winkelstellung des durch den Schlitz erzeugten Lichtbalkens so geändert wird, dass der Lichtbalken auf ein weiteres zu bestückendes Loch fällt, dass dann die Winkelinformation abgespeichert wird, dass dann die Blende soweit zurückgefahren wird, dass sich der Lichtbalken bis zu dem weiteren zu bestückenden Loch auf der Leiterplatte verkürzt und dass dann die Stellung der Blende abgespeichert wird.

## Claims

1. Device for equipping printed circuit boards, having an illuminating optical system for illuminating at least one aperture to be equipped, which optical system is movably disposed over the printed circuit board to be equipped, characterised in that the illuminating optical system (90, 16) is carried by a pantographic lever system (19, 81, 83, 84) and is movable in a plane parallel to the printed circuit board (2).

2. Device according to claim 1, characterised in that the pantographic lever system (19, 81, 83, 84) is connected to a co-ordinate table (66, 72, 78).

3. Device according to claim 1 or 2, characterised in that the illuminating optical system consists of a projection device (90) projecting parallel to the printed circuit board (2) and a mirror (16) arranged at the end of the arm (19) of the pantographic lever system (19, 81, 83, 84) that carries the illuminating device, which mirror deflects the projection rays at right angles to the printed circuit board (2).

4. Device according to claims 1 to 3, characterised in that the illuminating optical system contains a slide bar (9) that can be inserted into the optical path, which slide bar has at least one aperture (10) and one slot (12) and in that the slide bar can be rotated by 360° round the optical axis (24).

5. Device according to claim 4, characterised in that the slide bar (9) contains a further aperture (11) which is filled with a light-permeable coloured material, and in that this further aperture is disposed with the slot and the first mentioned aperture in a straight line.

6. Device according to claim 4 or 5, characterised in that in front of or behind the slide bar (9) there is disposed a displaceable diaphragm (7) by means of which the slot can be completely covered, and in that the diaphragm can be rotated with the slide bar by 360° round the optical axis.

7. Device according to claim 6, characterised in that the slide bar (9) and the diaphragm (7) are arranged displaceably in a rotatable part (22), and that the rotatable part (22) is disposed rotatably round the optical axis in a housing part (21).

8. Device according to claim 7, characterised in that the rotatable part can be rotated by means of a stepping motor (52) with respect to the housing part.

9. Device according to claim 8, characterised in that the stepping motor is secured to the housing part (21), in that a pinion (51) is connected to the axis of rotation of the stepping motor (52) and in that the pinion mates with a gear wheel (49) secured on the rotable part (22).

10. Device according to claim 8, characterised in that on the rotatable part (22) a cone ring (31) is provided which embraces the rotatable part and is displaceable with respect thereto in the direction of the optical axis, which cone ring has a cone surface that runs obliquely to the optical axis, on which surface the slide bar (9) abuts in sliding fashion.

11. Device according to one of claims 8 to 10, characterised in that on the rotatable part (22) an adjusting ring (36) is provided which is rotatable with the rotatable part but is displaceable with respect thereto in the direction of the optical axis, in that the adjusting ring (36) has an inner cone (37) and that the diaphragm if necessary can be displaced by sliding contact with the inner cone by the interconnection of a transmission lever.

12. Device according to claim 10, characterised in that the cone ring (31) can be adjusted in the direction of the optical axis by slide elements (45, 46) that lie on the front face, and that the slide elements can be adjusted between two positions in the direction of the optical axis by an electromagnet (58) by means of a jointed bracket (59).

13. Device according to claim 12, characterised in that the electromagnet (58) acts on the jointed bracket (59) by means of an oblique plane on the armature (60) of the electromagnet.

14. Device according to claim 13, characterised in that the adjusting ring (36) can be adjusted in the direction of the optical axis by means of slide elements (66) abutting it on the front face, and in that the slide elements (66) can be displaced in the direction of the optical axis by a jointed bracket (61) of a stepping motor (62) by means of a cam (63).

15. Device according to claims 11 and 12, characterised in that an electronic circuit is provided which has control means for the stepping motor (52) for rotating the rotatable part (22), the electromagnet (58) for shifting the slide bar (9), the stepping motor (62) for shifting the adjusting ring (36), a further stepping motor (74) for the one co-ordinate support (78) of the co-ordinate table and a further stepping motor (68) for the other co-ordinate support (72), in that the control means is connected to an input portion (93), into which information for the two co-ordinate supports, the angle and the length of the slot as well as the position of the slide bar (9) is fed, and in that a programme memory (92) is provided in which the information or the corresponding control signals of the control means can be stored into the input part.

16. Method for programming the programme memory of the device according to claim 15, characterised in that first of all the diaphragm is so shifted that it fully covers the slot in the slide bar, in that the light point produced by the relevant aperture in the slide bar is then placed onto an aperture in the printed circuit board to be equipped, by displacement of the co-ordinate support in both the co-ordinate directions, in that the co-ordinate information of the co-ordinate support is then stored, in that the diaphragm is then completely returned so that the slot near the light point appears in its full length on the printed circuit board, in that the angle position of the light bar produced by the slot is then so changed that the light bar falls onto a further aperture to be equipped, in that the angle information is then stored, in that the diaphragm is then returned so far that the light bar is shortened to the further aperture on the printed circuit board to be equipped, and in that the position of the diaphragm is then stored.

## Revendications

1. Dispositif pour équiper des plaquettes à circuit imprimé comportant un système optique (90, 16) pour l'éclairage d'au moins un trou (3) à équiper, ce dispositif étant mobile au-dessus de la plaquette (2) à circuit imprimé à équiper, caractérisé en ce que le système optique d'éclairage (90, 16) est porté par une tringlerie (19, 81, 83, 84) en forme de pantographe et qu'il est déplaçable dans un plan parallèle à la plaquette à circuit imprimé (2).

2. Dispositif suivant la revendication 1, caractérisé en ce que la tringlerie en forme de pantographe (19, 81, 83, 84) est reliée à une table à coordonnées (66, 72, 78).

3. Dispositif suivant l'une quelconque des revendications 1 et 2, caractérisé en ce que le système optique d'éclairage comprend un projecteur (90) projetant parallèlement à la plaquette à circuit imprimé (2) un miroir (16) placé à l'extrémité du bras (19) de la tringlerie en forme de pantographe (19, 81, 83, 84) portant le dispositif d'éclairage, le miroir déviant perpendiculairement sur la plaquette à circuit imprimé (2) les rayons projetés.

4. Dispositif suivant l'une quelconque des revendications 1 à 3, caractérisé en ce que le système optique d'éclairage comprend un coulisseau (9) insérable dans le trajet lumineux, ce coulisseau comportant au moins un trou (10) et une fente (12) et pouvant tourner de 360° autour de l'axe optique (24).

5. Dispositif suivant la revendication 4, caractérisé en ce que le coulisseau (9) comporte un autre trou (11), qui est rempli d'une matière colorée transparente et que cet autre trou est dans l'alignement de la fente et du premier trou.

6. Dispositif suivant l'une quelconque des revendications 4 et 5, caractérisé en ce qu'il est prévu, devant ou derrière le coulisseau (9), un écran mobile (7) au moyen duquel la fente est complètement obturable et que l'écran peut tourner, avec le coulisseau, de 360° autour de l'axe optique.

7. Dispositif suivant la revendication 6, caractérisé en ce que le coulisseau (9) et l'écran (7) sont disposés mobiles dans une pièce rotative (22) qui peut tourner, dans une partie de boîtier (21), autour de l'axe optique.

8. Dispositif suivant la revendication 7, caractérisé en ce que la pièce rotative (22) peut tourner par rapport à la partie de boîtier (21) au moyen d'un moteur pas-à-pas (52).

9. Dispositif suivant la revendication 8, caractérisé en ce que le moteur pas-à-pas est fixé à la partie de boîtier (21), qu'un pignon (51) est relié à l'axe de rotation du moteur pas-à-pas (52) et que le pignon engrène dans un pignon (49) fixé à la pièce rotative (22).

10. Dispositif suivant la revendication 8, caractérisé en ce que, sur la pièce rotative (22), il est prévu une bague conique (31) entourant la pièce rotative et mobile par rapport à celle-ci dans le sens de l'axe optique, la bague conique comportant une surface conique qui est oblique par rapport à l'axe optique et sur laquelle glisse le coulisseau (9).

11. Dispositif suivant l'une quelconque des revendications 8 à 10, caractérisé en ce qu'il est prévu sur la pièce rotative (22) und bague de réglage (36) qui peut tourner avec la pièce rotative, mais qui est mobile par rapport à celle-ci en direction de l'axe optique, que la bague de réglage (36) comporte un cône intérieur (37) et que l'écran est mobile par contact de glissement avec le cône intérieur, éventuellement sous l'action d'un levier de transmission interposé.

12. Dispositif suivant la revendication 10, caractérisé en ce que la bague conique (31) peut être déplacée en direction de l'axe optique par des éléments coulissants (45, 46) et que les éléments coulissants sont déplaçables, par l'intermédiaire d'un étrier articulé (59) et par un électro-aimant (58), entre deux positions dans le sens de l'axe optique.

13. Dispositif suivant la revendication 12, caractérisé en ce que l'électro-aimant (58) agit sur l'étrier articulé (59) au moyen d'une plan incliné de l'armature (60).

14. Dispositif suivant la revendication 13, caractérisé en ce que la bague de réglage (36) est mobile en direction de l'axe optique au moyen d'éléments coulissants (46) appliqués frontalement sur elle et que les éléments coulissants (46) sont déplaçables en direction de l'axe optique par l'intermédiaire d'un étrier articulé (61), sous l'action d'un moteur pas-à-pas (62) au moyen d'un taquet (63).

15. Dispositif suivant l'une quelconque des revendications 11 et 12, caractérisé en ce qu'il est prévu un montage électronique, qui comporte une commande pour le moteur pas-à-pas (52) destiné à la rotation de la pièce rotative (22), l'électro-aimant (58) destiné au déplacement du coulisseau (9), le moteur pas-à-pas (62) destiné au déplacement de la bague de réglage (36), un autre moteur pas-à-pas (74) pour un chariot à coordonnées (78) de la table à coordonnées ainsi qu'encore un autre moteur pas-à-pas (68) pour l'autre chariot à coordonnées (72) et en ce que la commande est reliée à un composant d'introduction (93) dans lequel sont introduites des informations pour les deux chariots à coordonnées (72, 78), l'angle et la longueur de la fente ainsi que la position du coulisseau (9) et qu'il est prévu une mémoire à programme (92) dans laquelle les informations introduites dans le composant d'introduction, c'est-à-dire les signaux de commande correspondants peuvent être mis en mémoire.

16. Méthode pour programmer la mémoire à programme du dispositif suivant la revendication 15, caractérisé en ce qu'elle consiste à tout d'abord déplacer l'écran de manière à recouvrir complètement la fente qui est dans le coulisseau; à appliquer ensuite le spot lumineux produit par le trou corespondant dans le coulisseau, par déplacement du chariot à coordonnées dans les deux sens de coordonnées, sur un trou à équiper de la plaquette à circuit imprimé; à mémoriser ensuite les informations de coordonnées du chariot à coordonnées; à ramener ensuite l'écran complètement en arrière, de sorte que la fente apparaît dans toute sa longueur, à côté du spot lumineux, sur la plaquette à circuit imprimé, qu'ensuite la position angulaire du trait lumineux produit par la fente change, de sorte que ce trait lumineux tombe sur un deuxième trou à équiper; à mémoriser ensuite l'information angulaire; à ramener ensuite l'écran en arrière de façon que le trait lumineux se raccourcisse jusqu'à l'autre trou à équiper sur la plaquette à circuit imprimé; et à mémoriser ensuite la position de l'écran.

FIG. 1

FIG. 2

a)

b)

c)

d)

e)

FIG. 3

a)

b)

c)

d)

e)

f)

0 008 694

FIG. 4

FIG. 7

FIG. 5

20

68

FIG. 8

X

Y

74

Schfen-Länge

62

Polaris

58

Winkel

52

Steuerung

91

Programm-Speicher

92

Eingabe

93

X
Y
Winkel
Lichtbalken-Länge
Polarisierung

Speicherbefehl

# FIG. 6